# EUROPEAN PATENT APPLICATION

(11) **EP 1 418 584 A1**
(43) Date of publication of application: **12.05.2004**
(21) Application number: 03720968.1
(22) Date of filing: 28.04.2003
(51) Int. Cl.: G11B 20/14, G11B 20/10

(54) **DIGITAL DATA RECORDING MEDIUM, RECORDING METHOD, RECORDING DEVICE, REPRODUCTION METHOD, AND REPRODUCTION DEVICE**

(30) Priority: 02.05.2002 JP 2002130430
(71) Applicant: Sony Corporation, Tokyo 141-0001 (JP); Sony Disc Technology Inc., Tokyo 141-0001 (JP)
(72) Inventor: SAKO, Yoichiro, c/o Sony Corporation, Tokyo 141-0001 (JP); INOKUCHI, Tatsuya, c/o Sony Corporation, Tokyo 141-0001 (JP); KIHARA, Takashi, Sony Human Capital Corporation, Tokyo 141-0001 (JP); AIDA, Toru, c/o Sony Disc Technology Inc., Tokyo 141-0001 (JP); SAITO, Akiya, c/o Sony Disc Technology Inc., Tokyo 141-0001 (JP); KANADA, Yoriaki, c/o Sony Corporation, Tokyo 141-0001 (JP); SANO, Tatsushi, c/o Sony Corporation, Tokyo 141-0001 (JP); FURUKAWA, Shunsuke, c/o Sony Corporation, Tokyo 141-0001 (JP); USUI, Yoshinobu, c/o Sony Disc Technology Inc., Tokyo 141-0001 (JP); SENNO, Toshihiko, c/o Sony Disc Technology Inc., Tokyo 141-001 (JP)
(74) Representative: Melzer, Wolfgang, Dipl.-Ing.
(86) International application number: PCT/JP2003/005467
(87) International publication number: WO 2003/094165

(57) **Abstract**

A method for recording data comprising: forming recording data by adding a pattern of connection bits selected from among a plurality of patterns of connection bits to the end of an m-bit data symbol, the selected pattern of connection bits causing an increase in an accumulated value of direct-current components per unit time when the n-bit data symbol is a special data symbol and is added to a data symbol other than the special data symbol, when m-bit data is converted into the n-bit data symbol (m<n) and when the pattern of connection bits is selected from among the plurality of patterns of connection bits to decrease the accumulated value of direct-current components per unit time to be added to the end of the m-bit data symbol; and recording the recording data formed and data indicating a recorded location of the special data symbol on a recording medium.

## Description

### Technical Field

The present invention relates to a recording medium, a recording method, a recorder, a playback method, and a player for digital data.

### Background Art

Compact discs (CD) are widely used as media for storing various data such as digital audio data and image data, or computer programs because CDs are easy to produce, inexpensive, and easily handled.

Nowadays, however, the improved performance of personal computers and the advent of recordable compact discs (CD-R) and re-writable compact discs (CD-RW) allow the digital data stored in CDs to be readily copied. In general, copying data from a CD to a CD-R or a CD-RW infringes on copyright. Accordingly, some measures are required for copyright protection of the digital data stored in CDs.

Even in the event that such copying does not happen, highly confidential data stored in CDs must be protected so that the data cannot be readily retrieved.

In light of these circumstances, the present invention is directed to ensuring the security of the content of an original CD and to preventing a copied CD from being played back or read. In the following description, the CD includes a compact disc-digital audio (CD-DA), a compact disc read-only memory (CD-ROM), and the like.

### Disclosure of Invention

The present invention provides a method for recording data comprising: forming recording data by adding a pattern of connection bits selected from among a plurality of patterns of connection bits to the end of an m-bit data symbol, the selected pattern of connection bits causing an increase in an accumulated value of direct-current components per unit time when the n-bit data symbol is a special data symbol and is added to a data symbol other than the special data symbol, when m-bit data is converted into the n-bit data symbol (m<n) and when the pattern of connection bits is selected from among the plurality of patterns of connection bits to decrease the accumulated value of direct-current components per unit time to be added to the end of the m-bit data symbol; and recording the recording data formed and data indicating a recorded location of the special data symbol on a recording medium.

### Brief Description of the Drawings

Fig. 1A is an illustration for explanation of the present invention.
Fig. 1B is an illustration for explanation of the present invention.
Fig. 1C is an illustration for explanation of the present invention.
Fig. 1D is an illustration for explanation of the present invention.
Fig. 1E is an illustration for explanation of the present invention.
Fig. 2 is a block diagram showing an embodiment of the present invention.
Fig. 3A is an illustration for explanation of the present invention.
Fig. 3B is an illustration for explanation of the present invention.
Fig. 3C is an illustration for explanation of the present invention.
Fig. 3D is an illustration for explanation of the present invention.
Fig. 4 is a block diagram showing an embodiment of the present invention.
Fig. 5 is a block diagram showing another embodiment of the present invention.

### Best Mode for Carrying Out the Invention

A recording medium, a recorder, and a player according to the present invention will now be described below with reference to the drawings.

### (1) DSV of a CD

In a CD, one sample of digital audio data consists of 16 bits. When the 16-bit digital audio data is divided into eight higher-order bits and eight lower-order bits, the divided data is encoded under a cross interleave Reed-Solomon code (CIRC) scheme and is modulated under an eight-to-fourteen modulation (EFM) scheme for every eight bits of data. The modulated output data is recorded on the CD in the form of a spiral recording track. Each 8-bit unit is called a symbol.

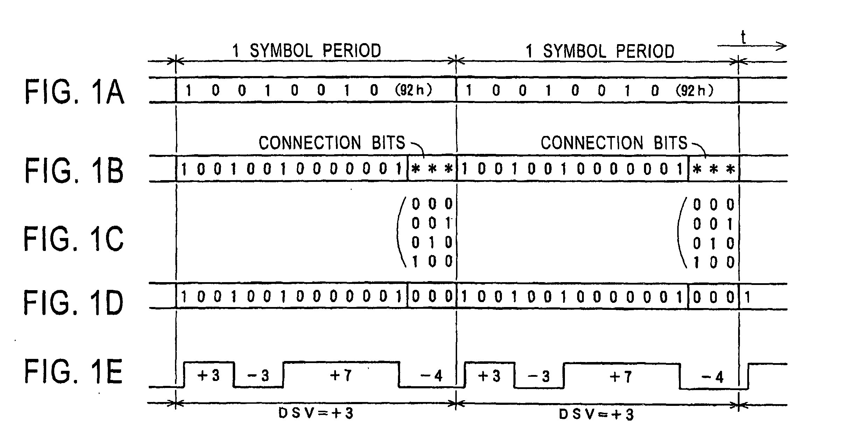

Referring to Fig. 1A, the value of a symbol (original data) is, for example, 92h (h denotes a hexadecimal value). When this symbol is CIRC-encoded and is modulated to an EFM modulated signal, the channel bits (in the EFM modulated signal) are represented as the bit sequence shown in Fig. 1B according to a standard used in CDs. In this process, three bits, which are called connection bits or merging bits, are added in between the symbols.

These connection bits are added to increase the minimum time Tₘᵢₙ and to decrease the maximum time Tₘₐₓ between the symbols, specifically, to ensure that at least two but less than twelve "0s" or "1s" appear continuously. As the connection bits, one pattern is selected from four patterns consisting of '000,' '001,' '010,' and '100,' as shown in Fig. 1C. In this case, "000" is selected based on the above described conditions.

Therefore, the channel bits have a bit pattern shown in Fig. 1D. The digital sum variation (DSV) in this case is determined as shown in Fig. 1E. At the completion of processing one symbol period, the DSV increases by three. If the original data is common digital audio data and the like, the connection bits are selected so that the DSV per symbol varies in positive or negative polarity and in magnitude so that the accumulated DSV converges as close as possible on zero. As a result, the accumulated DSV always remains within a predetermined range around zero.

However, if a special data symbol such as 92h repeats in some way, the connection bits repeat "000" and thus the accumulated DSV increases by three for each symbol. Such an increase (or decrease) in the DSV in this manner results in a deviation of the accumulated DSV from a certain range and affects asymmetry correction in a playback circuit for the CD, leading to a failure of normal playback.

In consideration of these features, the present invention is directed to protecting data and preventing copying.

### (2) Embodiment of Recorder

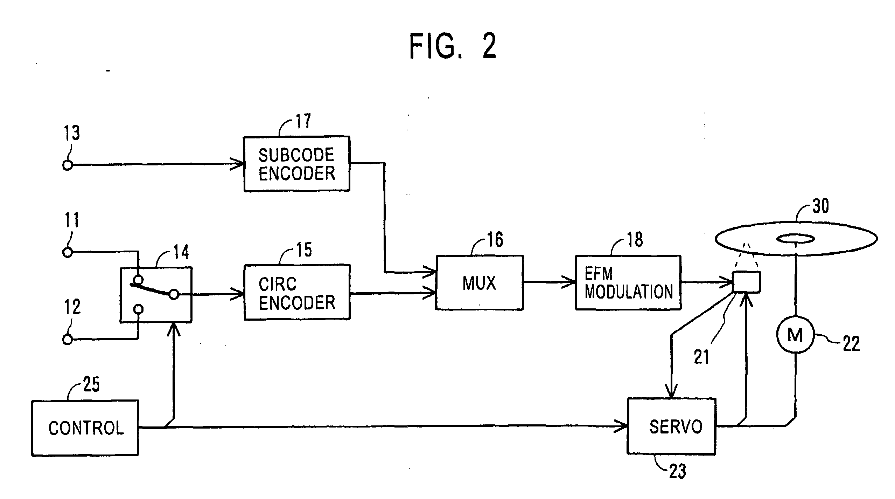

Fig. 2 shows the embodiment of the recorder applying Section (1) above. Main data is supplied to a terminal 11; special data for the main data is supplied to a terminal 12; and subcode data is supplied to a terminal 13. The main data supplied to the terminal 11 includes encrypted data in which the original data (plaintext data) to be secured is encrypted and data on an encryption key used for the encryption. The encrypted data and the encryption key data may be divided into a plurality of data groups.

The special data supplied to the terminal 12 is, for example, data repeating 92h, and is also data having a biased DSV causing an error during playback because the connection bits are limited to a particular pattern among possible patterns, as described in Section (1). The subcode data supplied to the terminal 13 includes information on an area where the special data is recorded on the CD, as will be described below. This subcode data may include a portion of the main data.

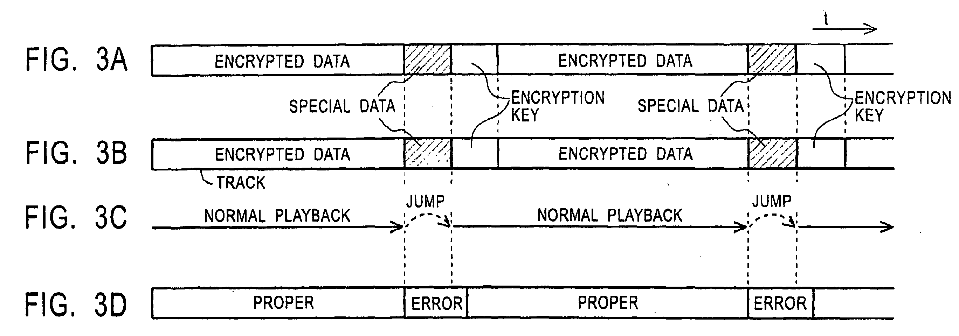

The main data at the terminal 11 and the special data at the terminal 12 are supplied to a switching circuit 14 to which a control signal is supplied by a system control circuit 25. As shown in Fig. 3A, the main data having the special data in a period prior to and directly or indirectly adjacent to the encryption key data is retrieved from the switching circuit 14.

Subsequently, this output from the switching circuit 14 is supplied to a CIRC encoder circuit 15 for CIRC encoding. The encoded output is supplied to a multiplexer circuit 16. The subcode data at the terminal 13 is supplied to a subcode encoder circuit 17 for encoding. The encoded data is then supplied to the multiplexer circuit 16. The subcode data at the terminal 13 includes the information on the insertion area of the special data, as described above. In this way, the encoded output for the main data is retrieved from the multiplexer circuit 16, the main data having the special data at the period prior to and directly or indirectly adjacent to the encryption key data and having the added subcode data.

This encoded data is supplied to an EFM modulation circuit 18. At the EFM modulation circuit 18, one pattern of the connection bits is selected from among the four patterns of connection bits, as described above. When the value of the data symbol is 92h, the connection bits "000" are selected, as described above. In this way, the data is converted to EFM modulated signals (the channel bits). These modulated signals are supplied to an optical recording head 21, and are then recorded on a recordable optical disc 30 such as a CD-R disc (or a master) to form spiral recording tracks. During this operation, the optical disc 30 is rotated by a spindle motor 22 at a predetermined linear velocity and is subjected to various types of servo system control for recording using a servo system circuit 23 such as servo control for tracking or focusing, or control of the recording electrical current supplied to the optical head 21.

The data is recorded on the optical disc 30 as described above. The main data having the encrypted data and the encryption key data, and the special data are recorded on the recording tracks of the optical disc 30, as shown in Fig. 3B. The special data is disposed in the area prior to and directly or indirectly adjacent to the recorded area of the encryption key data. The information on the recorded area of the special data is included in the subcode data.

### (3) Embodiment of Player

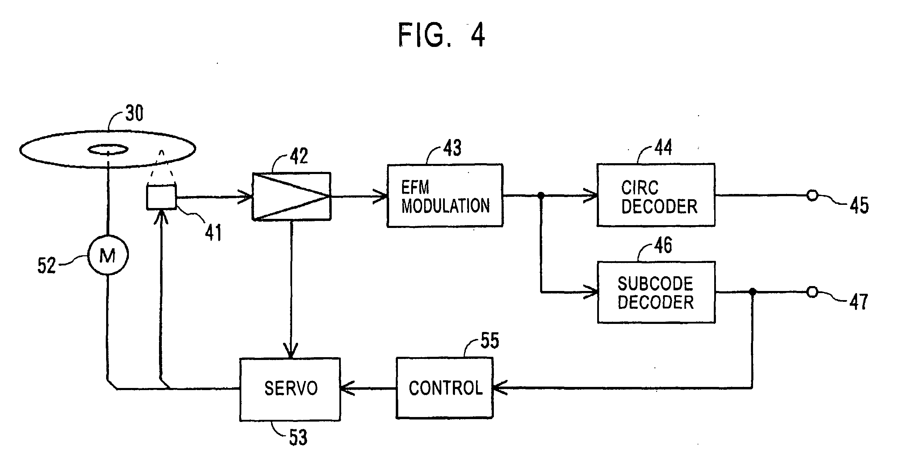

Fig. 4 shows an embodiment of a player for playing back the optical disc 30 prepared by the recorder in Section (2) above. From the optical disc 30 prepared according to Section (2) (or an optical disc whose master is the optical disc prepared according to Section (2)), an EFM modulated signal is read by a playback optical head 41. During this operation, the optical disc 30 is rotated by a spindle motor 52 at a predetermined linear velocity. A servo system circuit 53 performs various types of servo system control for playback, such as servo control of the spindle motor 52, or servo control for tracking or focusing of the optical head 41.

The optical head 41 outputs signals to an EFM demodulation circuit 43 through an amplifier 42 for obtaining a demodulated original data string (a CIRC signal). This data string is supplied to a CIRC decoder circuit 44. The output data from the EFM demodulation circuit 43 is supplied to a subcode decoder circuit 46 to decode the subcode data. This subcode data is retrieved at a terminal 47 and is also supplied to a system control circuit 55.

In the system control circuit 55, the information on the recorded area of the special data is retrieved from the supplied subcode data, and the playback position of the optical disc 30 is controlled as shown in Fig. 3C. Specifically, during playback of the optical disc 30 with the optical head 41 from, for example, the start of the track, when the playback position reaches the start of the recorded area of the special data indicated by the subcode data, the system control circuit 55 directs the servo system circuit 53 to jump over the following recorded area of the special data. As a result, the servo system circuit 53 makes the optical head 51 perform a track jump so that the playback position jumps to the start of the area where the encryption key data is recorded, which is located after the recorded area of the special data, and a normal playback operation continues thereafter.

Consequently, even if the special data is recorded on the optical disc 30, only the CIRC encoded signal of the main data, which includes no special data, that is, the encrypted data and the encryption key data, is supplied to the CIRC decoder circuit 44. Thus, in the CIRC decoder circuit 44, the encrypted data and the encryption key data are normally decoded to be output to a terminal 45. Accordingly, the encrypted data is decoded using the encryption key data output to the terminal 45, so that the original data (the plaintext data) is obtained.

By contrast, during playback of the optical disc 30 with a common CD-ROM drive, or a common optical disc player, in which the optical head 41 plays back from, for example, the start of the track, the recorded area of the special data is also played back. Referring to Fig. 3D, the DSV deviates from an allowable range in the CIRC decoder circuit 44 during the playback of the recorded area of the special data, resulting in playback errors. Since the errors cannot be immediately recovered from, it is impossible to play back the area where the encryption key data is recorded, which follows the recorded area of the special data.

Therefore, the encrypted data is output to the terminal 45, but the encryption key data for decryption of the encrypted data is not normally output. As a result, the encrypted data cannot be decoded, thereby securing the encrypted data.

If attempts are made to copy the optical disc 30 using two common apparatuses for recording and playing back optical discs, such as CD-ROM drives, the encryption key data following the recorded area of the special data is not normally played back, as explained with reference to Fig. 3D. Thus, it is virtually impossible to copy the data included, ensuring copy protection.

### (4) Another Embodiment of Recorder

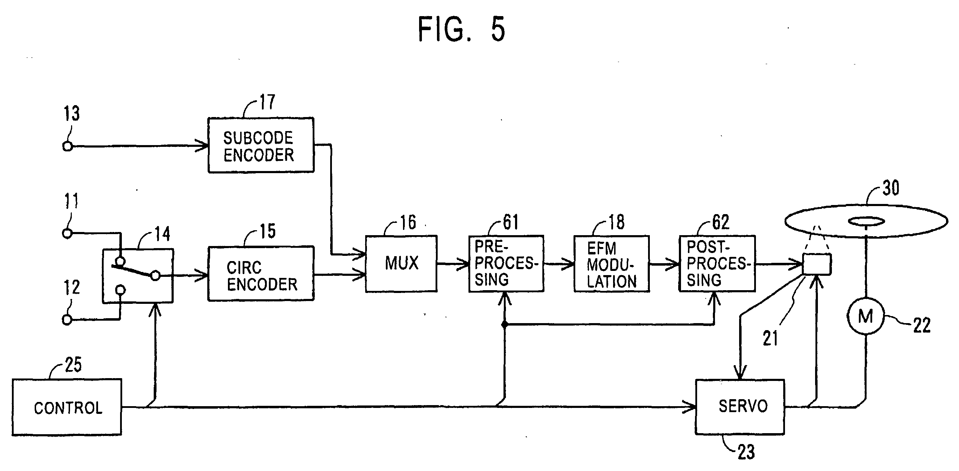

Fig. 5 shows another embodiment of the recorder. In this recorder, a pre-processing circuit 61 and a post-processing circuit 62 are provided at the input and the output of the EFM modulation circuit 18, respectively. From the control circuit 55, a signal indicating the recorded area of the special data is supplied to the processing circuit 61 and the processing circuit 62, which perform operations for preventing other types of illegal playback or copying. Examples of such an operation include the generation of a bit pattern of at most two "0s" or "1s" appearing continuously as the minimum time Tₘᵢₙ, bit manipulation causing a parity error, and shifting of the channel bits. A corresponding recorder carries out processing complementary to the processing of this recorder.

Consequently, the optical disc 30 prepared by this recorder more effectively protects the security of the encrypted data against unauthorized copying.

### (5) Other applications

In the embodiments as described above, the subcode data includes the information on the recorded area of the special data. The subcode data may also include information on the area where the main data is recorded, thus allowing only the area indicated by the information included in the subcode data, i.e., the special data, to be played back. The above examples are designed to dispose the special data in the area prior to and directly or indirectly adjacent to the area where the encryption key data is recorded. Alternatively, the special data may be disposed in an area that is subsequent to and directly or indirectly adjacent to the area where the encryption key data is recorded since data is recorded block by block during recording of the data on the CD, and so this arrangement also causes errors during playback of encryption key data, thus protecting the data.

Non-standard processing such as special control of the connection bits, use of a special translation table, conversion of data, or insertion of the special data into the subcode data may prevent an abnormal DSV of the original disc. Although the encoding and decoding operate under the CIRC scheme in the above examples, the present invention may be applied to a case where a single error correction code, such as cyclic redundancy check (CRC) or Reed-Solomon code, is employed.

Although a CD is used in the above examples as the recording medium, a mini disk (MD), a digital versatile disk (DVD), or transmission and reception over a network such as the Internet may be used. Either the processing circuit 61 or the processing circuit 62 may be omitted from the recorder shown in Fig. 5.

### Industrial Applicability

According to the present invention, a normal CD player fails to reproduce the encryption key necessary for decoding the encrypted data, thus allowing data security and virtually preventing illegal copying.

## Claims

1. A method for recording data comprising:
forming recording data by adding a pattern of connection bits selected from among a plurality of patterns of connection bits to the end of an m-bit data symbol, the selected pattern of connection bits causing an increase in an accumulated value of direct-current components per unit time when the n-bit data symbol is a special data symbol and is added to a data symbol other than the special data symbol when m-bit data is converted into the n-bit data symbol (m<n) and when the pattern of connection bits is selected from among the plurality of patterns of connection bits to decrease the accumulated value of direct-current components per unit time to be added to the end of the m-bit data symbol; and
recording the recording data formed and data indicating a recorded location of the special data symbol on a recording medium.

2. The method according to claim 1, wherein the m-bit data includes encryption key data and encrypted data encrypted using the encryption key, and the data including the special data symbol is recorded in a location directly or indirectly adjacent to the encryption key data.

3. The method according to claim 2, wherein the data including the special data symbol is recorded in a location prior to and directly or indirectly adjacent to the encryption key data.

4. The method according to claim 1, wherein when the n-bit data symbol is a special data symbol, a particular pattern of connection bits is selected from among the plurality of the patterns of connection bits and the selected pattern of connection bits is added for forming the recording data.

5. The method according to claim 1, wherein when the n-bit data symbol is a special data symbol, a particular pattern of connection bits is selected from among the plurality of the patterns of connection bits and the selected pattern of connection bits is added for forming the recording data.

6. A recorder comprising:
a formation section for forming recording data after m-bit data is converted into n-bit data (m<n) to increase an accumulated value when the m-bit data of which n-bit preceding data is special data is followed by data other than the special data; and
a recording section for recording the recording data formed by the formation section and data indicating a recorded location of the special data on a recording medium.

7. The recorder according to claim 6, wherein the n-bit data includes a data symbol having n1 bits and connection bits having n2 bits, a pattern of the connection bits is selected from among a plurality of patterns of connection bits so that the accumulated value of direct-current components per unit time decreases, and the formation section forms recording data by adding a particular pattern of connection bits selected from among the plurality of patterns of connection bits when the data symbol having n1 bits is a special data symbol.

8. The recorder according to claim 6, wherein the m-bit data includes encryption key data and encrypted data encrypted using the encryption key data, and data including the special data symbol is recorded in a location directly or indirectly adjacent to the encryption key data by the recording section.

9. The recorder according to claim 8, wherein the data including the special data symbol is recorded in a location prior to and directly or indirectly adjacent to the encryption key data.

10. A method for playing back a recording medium of which data is recorded after m-bit data is converted into n-bit data (m<n) to increase an accumulated value when the m-bit data of which n-bit preceding data is special data is followed by data other than the special data, comprising:
playing back a portion other than a portion including the recorded special data.

11. The method according to claim 10, wherein in the recording medium, data indicating a location of the special data is further recorded, the method further comprising jumping over a recorded portion of the special data based on the data indicating the location.

12. The method according to claim 11, wherein the method includes performing a track jump operation based on the data indicating the location.

13. The method according to claim 12, wherein the m-bit data includes encryption key data and encrypted data encrypted using the encryption key data, and the special data is recorded in a location directly or indirectly adjacent to the encryption key data, the method further comprising performing a track jump over a recorded portion of the special data and reading the encryption key data.

14. The method according to claim 13, further comprising a decoding operation for the encrypted data using the read encryption key data.

15. The method according to claim 13, wherein the special data is recorded in a location prior to and directly or indirectly adjacent to the encryption key data.

16. A method for playing back a recording medium of which data is recorded after m-bit data is converted into n-bit data (m<n) to increase an accumulated value when the m-bit data of which n-bit preceding data is special data is followed by data other than the special data, comprising:
performing a track jump over a recorded portion of the special data.

17. The method according to claim 16, wherein the m-bit data includes encryption key data and encrypted data encrypted using the encryption key data, and the special data is recorded in a location directly or indirectly adjacent to the encryption key data, the method further comprising performing a track jump over a recorded portion of the special data and reading the encryption key data.

18. The method according to claim 17, further comprising a decoding operation for the encrypted data using the read encryption key data.

19. The method according to claim 17, wherein the special data is recorded in a location prior to and directly or indirectly adjacent to the encryption key data.

20. A player comprising:
an optical head for reading data recorded in a recording medium after m-bit data is converted into n-bit data (m<n) to increase an accumulated value when the m-bit data of which n-bit preceding data is special data is followed by data other than the special data;
a decoding section for decoding an output signal from the optical head; and
a control section for controlling the optical head to read data other than a recorded portion of the special data.

21. The player according to claim 20, wherein the control section controls the optical head to perform a track jump over a recorded portion of the special data in the recording medium.

22. The player according to claim 21, wherein the m-bit data includes encryption key data and encrypted data encrypted using the encryption key data, the special data is recorded in a location directly or indirectly adjacent to the encryption key data, the player controls, using the controller, the optical head to perform a track jump over a recorded portion of the special data, and the encryption key data is read from the recording medium.

23. The player according to claim 22, wherein the decoding section decodes the encrypted data read from the recording medium using the read encryption key data.

24. The player according to claim 22, wherein the special data is recorded in a location prior to and directly or indirectly adjacent to the encryption key data.
